# FASCICULE DE BREVET EUROPEEN

(11) **EP 2 388 822 B1**
(45) Date de publication et mention de la délivrance du brevet: **18.07.2018**
(21) Numéro de dépôt: 11354021.5
(22) Date de dépôt: 10.05.2011
(51) Int. Cl.: H01L 27/146

(54) **PROCÉDÉ DE MISE EN FONTIONNEMENT D'UN DÉTECTEUR INFRAROUGE REFROIDI**
VERFAHREN ZUR INBETRIEBNAHME EINES ABGEKÜHLTEN INFRAROTSENSORS
METHOD FOR OPERATING A COOLED INFRARED DETECTOR

(30) Priorité: 17.05.2010 FR 1002065
(43) Date de publication de la demande: 23.11.2011
(73) Titulaire: Société Française de Détecteurs Infrarouges - SOFRADIR, 91120 Palaiseau (FR)
(72) Inventeur: Rubaldo, Laurent, 38600 Fontaine (FR); Maillart, Patrick, 38140 La Murette (FR); Zécri, Michel, 38600 Bévénais (FR)
(74) Mandataire: Talbot, Alexandre

(56) Documents cités:
- US-A- 4 628 695
- US-A- 5 030 831
- US-A1- 2005 083 567

## Description

### Domaine technique de l'invention

L'invention est relative à un procédé de mise en fonctionnement d'un détecteur infrarouge muni d'un photodétecteur, comportant l'abaissement de la température du photodétecteur.

### État de la technique

Lors de la conception d'une matrice de photodétecteurs d'un détecteur infrarouge, il y a toujours des disparités qui existent entre les différents photodétecteurs. Bien que ces derniers soient réalisés de la même manière, au moyen des mêmes procédés, dans les mêmes machines et simultanément, il n'est pas possible d'empêcher certains photodétecteurs (et donc certains pixels) d'avoir un comportement atypique caractérisé par un niveau de sortie différent des autres photodétecteurs et/ou un excès de bruit.

Ce problème est particulièrement gênant dans le domaine des photodétecteurs refroidis pour lequel ces pixels atypiques ou défectueux peuvent engendrer des fausses alarmes. Ces photodétecteurs peuvent présenter, par exemple, des niveaux de bruit élevés ou des niveaux de sortie très différents des autres, ce qui réduit fortement les performances du photodétecteur et/ou les performances de la matrice de photodétecteurs.

Il existe également une évolution des pixels défectueux en fonction de la température de fonctionnement, tant en nombre qu'au regard de leurs performances électriques.

Une manière simple de contrecarrer ce problème est de réaliser une calibration en usine, de déterminer quels sont les pixels atypiques et d'exclure artificiellement les pixels atypiques de la matrice. Quand cela est possible, cette opération est réalisée régulièrement afin de prendre en compte les évolutions de la répartition des pixels défectueux. Cependant, dans de nombreuses applications, il n'est pas possible de réaliser une calibration après être sortie de l'usine de fabrication et/ou une calibration en mode opérationnel.

Bien qu'il soit établi que ces dérives dans le fonctionnement des photodétecteurs soient liées aux pièges électriquement actifs présents dans la bande interdite du matériau sensible du photodétecteur et/ou des différents matériaux utilisés dans la réalisation, aucune solution n'a été proposée afin de réduire efficacement et durablement leur influence.

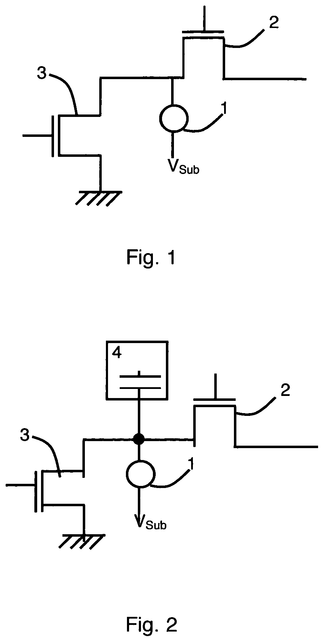

Le document US 5 030 831 divulgue un procédé de mise en fonctionnement d'une photodiode en polarisation directe avec abaissement de la température à une température de 77 K (figure 1, photodiode 3, 7, 5, col. 3, ligne 36 à col. 4, ligne 23).

Le document US 2005/0083567 A1 divulgue un procédé de mise en fonctionnement d'une photodiode (PD) fonctionnant à une température de 77K en mode de polarisation inverse, voir [0043], [0058], [0063].

### Objet de l'invention

L'invention a pour objet un procédé qui soit facile à mettre en oeuvre et qui permet de réduire la probabilité pour un photodétecteur d'avoir un comportement atypique.

Le procédé selon l'invention est caractérisé par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés au dessin annexé, dans lequel les figures 1 et 2 représentent, de manière schématique, des modes de réalisation particuliers d'un détecteur infrarouge.

### Description d'un mode préférentiel de l'invention

Le détecteur infrarouge comporte un photodétecteur 1 fonctionnant à basse température, c'est-à-dire un photodétecteur 1 qui a besoin d'être refroidi afin de fonctionner normalement.

Comme illustrée à la figure 1, le photodétecteur 1 est une photodiode qui est polarisée en inverse, plus précisément une photodiode de type N/P. De cette manière, la photodiode délivre un courant représentatif de la scène observée ce qui permet sa quantification. Le photodétecteur 1 fonctionne à basse température, typiquement la température de travail est inférieure à 20°C, avantageusement à une température inférieure à -73°C, de préférence entre -225°C et -73°C. Le photodétecteur 1 à basse température est, par exemple, une photodiode à base de CdHgTe, InSb ou InGaAs. Il est possible d'utiliser n'importe quel détecteur dit quantique ou photovoltaïque de l'infrarouge lointain au visible donc dans des longueurs d'onde comprises entre 0,4µm et 20µm pour une gamme de température allant de la température ambiante à -269°C.

Lors de la mise en fonctionnement du détecteur infrarouge refroidi, il y a abaissement de la température du photodétecteur 1. Ainsi, le photodétecteur voit sa température baisser d'une première température qui est, par exemple la température ambiante jusqu'à une seconde température, par exemple, sa température de travail. La seconde température est inférieure à la première température et la température de travail peut être inférieure ou égale à la seconde température. Lors de cet abaissement de température, ou durant au moins une partie de cet abaissement de température, le photodétecteur est polarisé en direct. Cette polarisation en direct se traduit par le passage d'un courant de porteurs majoritaires à travers le photodétecteur.

Il a été découvert que l'application de cette polarisation directe se traduit par une diminution de la probabilité pour le photodétecteur de présenter un comportement atypique et/ou un excès de bruit. Il en résulte alors que dans la matrice de photodétecteurs, il y a réduction du nombre de photodétecteurs présentant un comportement atypique.

Bien que cela ne soit pas encore vérifié, il est avancé l'hypothèse que le courant de porteurs majoritaires permet de remplir les pièges électroniques présents dans le photodétecteur et/ou de recombiner les porteurs piégés sur les défauts électroniques dans le photodétecteur.

De cette manière, la polarisation en direct du photodétecteur lors de l'abaissement de température permet de fixer l'état d'une grande partie des pièges électroniques et donc de masquer leur effet sur le photodétecteur.

Le fait d'appliquer cette polarisation directe durant la mise en froid permet d'une part de garantir l'efficacité de la recombinaison et/ou du piégeage car cette opération est commencée à une température supérieure à la température de travail tout en préservant l'intégrité du photodétecteur (la montée en température liée au fort courant et à la polarisation directe est évitée). D'autre part, cette opération permet de gagner du temps en mode opérationnel, en utilisant le temps perdu de la descente en température pour effectuer le protocole de masquage des défauts.
Le photodétecteur présente alors un nombre réduit de pièges électroniques actifs ce qui réduit fortement sa probabilité d'être bruitée et d'avoir un comportement atypique.

Ainsi, de manière simple, dans une matrice de photodiodes, la polarisation en direct des photodiodes lors de l'abaissement de la température permet, de manière non négligeable, de réduire la quantité de photodiodes atypiques (de pixels atypiques). Ce procédé, au lieu d'éliminer artificiellement les pixels atypiques de la zone de mesure en excluant ceux dont le fonctionnement est suspect, permet d'augmenter le nombre de pixels en gelant l'effet d'une partie des pièges électroniques présents dans les photodiodes. Cet effet de gel est particulièrement efficace pour des températures inférieures à -73°C.
Dans un mode de réalisation particulier illustré à la figure 1, le détecteur infrarouge comporte un photodétecteur 1 connecté en série avec un transistor de polarisation 2. Le photodétecteur 1 comporte une première borne commune avec le transistor de polarisation 2. L'autre borne du photodétecteur 1 est reliée à une prise de potentiel V_{sub}, par exemple une prise de potentiel représentative du potentiel du substrat sur lequel est intégré le photodétecteur 1. De cette manière, une des bornes du photodétecteur 1 a un potentiel qui est égal à celui du substrat. De manière classique, le passage du transistor de polarisation 2 dans un état passant permet de polariser la photodiode en inverse. Le transistor de polarisation 2 est connecté entre le photodétecteur 1 et des moyens d'application d'une polarisation inverse.

Le détecteur infrarouge comporte également un transistor additionnel 3 qui possède une première borne connectée à la première borne du transistor de polarisation 2, c'est-à-dire à la borne commune entre le photodétecteur 1 et le transistor de polarisation 2. La seconde borne du transistor additionnel 3 est reliée à un potentiel prédéterminé, par exemple la masse qui permet d'appliquer une seconde polarisation au photodétecteur, la polarisation directe.

Le transistor de polarisation 2 et le transistor additionnel 3 possèdent tous les deux une borne de commande qui permet selon les polarisation appliquées de mettre le transistor dans un état bloquant ou passant. Le transistor de polarisation est, par exemple, un transistor à effet de champ de type MOS, ou un transistor bipolaire ou de type JFET ou tout autre composant actif qui permet de moduler le courant appliqué.

Lors de sa mise en fonctionnement, c'est-à-dire de son conditionnement, il y a abaissement de la température du photodétecteur 1 et éventuellement d'une partie du circuit électronique qui lui est associé. La température d'au moins une partie du détecteur infrarouge (au moins le photodétecteur) passe d'une première température (par exemple la température ambiante) à une seconde température inférieure à la première, par exemple la température de travail. Lors de cet abaissement de la température, la polarisation en direct du photodétecteur et l'injection de porteurs dans le photodétecteur permet de guérir ou de masquer une partie des défauts liés au procédé de réalisation du photodétecteur. De ce fait, lors de la descente en température, il y a passage d'un courant de porteurs majoritaires à travers le photodétecteur 1.

Avantageusement, la polarisation en direct et l'injection de porteurs sont réalisées durant toute la descente en température, mais il est également envisageable de ne réaliser le passage du courant que durant une ou plusieurs parties de la descente en température.

Une fois la seconde température ou la température de travail atteinte, le photodétecteur n'est plus polarisé en direct. il est polarisé en inverse afin de jouer le rôle de photodétecteur qui délivre un courant représentatif de la scène observée.
De cette manière, les états de charges, les pièges et d'une manière générale une partie des défauts présents dans le photodétecteur 1 sont fixés par les porteurs provenant du courant lié à la polarisation directe du photodétecteur. Les porteurs majoritaires recombinent et/ou saturent les pièges ce qui fixe leur état initial de manière identique à chaque mise en froid. Cet état pouvant être conservé au moyen du travail continu à basse température du photodétecteur 1 sous un même type de polarisation, une polarisation inverse. Avantageusement, le travail à une température inférieure à -73°C permet une meilleure fixation des porteurs majoritaires sur les défauts.
La mise en place de la polarisation directe du photodétecteur lors de l'abaissement de température peut être réalisée de manière manuelle ou de manière automatisée.
A titre d'exemple, si le transistor additionnel est de type NMOS et est connecté à la masse, le passage à un état passant est réalisé en appliquant un potentiel supérieur ou égale à 0,7V sur l'électrode de commande. Si le transistor de polarisation est de type NMOS, le passage à un état bloqué est réalisé en appliquant un potentiel de l'ordre de 0V sur l'électrode de commande. Le basculement des transistors de polarisation 2 et additionnel 3 entre leurs états passant et bloquant permet de passer le photodétecteur dans une polarisation directe ou une polarisation inverse. De manière préférentielle, les états du transistor de polarisation et du transistor additionnel sont opposés.

Durant la phase de polarisation directe du photodétecteur, un potentiel fixe dépendant du type de photodétecteur (par exemple des photodiodes P/N ou N/P) est appliqué. En l'occurrence, le potentiel de la photodiode est fixé via le potentiel du substrat V_{SUB}, par exemple, à 3,3V pour la photodiode P/N.

En commençant l'opération de masquage à une température supérieure à la température de travail du dispositif, on s'autorise un masquage de tous les défauts ou une plus grande probabilité de masquer ces défauts ce qui n'est pas possible à la température de travail. Le fait de descendre en température permet de geler le masquage obtenu à une température plus élevée.

En d'autres termes, en travaillant à haute température, le remplissage et le masquage de tous les défauts présents dans la bande interdite est facilité. En arrivant à la température de travail, on s'assure que la majorité voire la totalité des pièges ont interagi avec le courant de porteurs majoritaires.

Cette dissociation de la phase de masquage (lors de la descente en température) et de la phase de fonctionnement utile (la phase d'acquisition des données) à la température de travail permet de maintenir des fréquences de rafraichissement élevées du photodétecteur 1 associé à son circuit de lecture 4. De cette manière, les défauts présents sont masqués par les porteurs majoritaires et, durant la phase d'acquisition (mode fonctionnel), des fréquences supérieures à 100Hz sont accessibles, typiquement des fréquences de l'ordre de 2kHz. La phase d'acquisition est réalisée en polarisant le photodétecteur en inverse.

Lors de la phase d'acquisition, le photodétecteur est associé à un circuit de lecture du rayonnement reçu par la photodiode 1. Le circuit de lecture 4 comporte des moyens de lecture de l'information émise par la photodiode et stockée dans une charge capacitive. De manière préférentielle illustrée à la figure 2, le circuit de lecture 4 comporte également des moyens de remise à zéro de la charge capacitive afin de réaliser une pluralité d'acquisitions à la fréquence désirée, par exemple un transistor monté en parallèle du condensateur. Le circuit de lecture 4 est par exemple un circuit de type injection directe, injection directe contre-réactionnée ou amplificateur transimpédance capacitif. Il est également envisageable d'utiliser le condensateur interne de la photodiode 1. La polarisation inverse peut également être appliquée directement par le circuit de lecture 4 et le transistor 2 est alors disposé entre la photodiode 1 et le circuit de lecture 4.

Durant l'acquisition de l'information, le photodétecteur est soumis à une première polarisation qui permet la transformation du signal lumineux émis par la scène en un signal électrique représentatif. Durant la descente en température du détecteur infrarouge, le photodétecteur est soumis à une seconde polarisation qui est opposée à la première polarisation et appelée de manière générique « polarisation inverse » en assimilant le détecteur à une diode.

## Revendications

1. Procédé de mise en fonctionnement d'un détecteur infrarouge, comportant
- fournir le détecteur infrarouge muni d'une photodiode (1) et d'un circuit de lecture (4) connecté à la photodiode (1),
- abaisser la température de la photodiode (1) depuis une première température jusqu'à une température de travail inférieure à la première température et inférieure à -73°C,
- appliquer une polarisation directe aux bornes de la photodiode (1) pour générer un courant de porteurs majoritaires durant l'abaissement de température depuis la première température jusqu'à une seconde température supérieure ou égale à la température de travail, et
- appliquer une polarisation inverse aux bornes de la photodiode (1) après que la photodiode (1) a atteint la température de travail de manière à ce que la photodiode (1) transforme un signal optique en un signal électrique tout en maintenant la température de la photodiode (1) à la température de travail.

2. Procédé selon la revendication 1, **caractérisé en ce que** le détecteur infrarouge comporte un transistor de polarisation (2) monté en série avec la photodiode (1) et un transistor additionnel (3) ayant une première borne connectée à la borne commune du transistor de polarisation (2) et de la photodiode (1) et une seconde borne connectée à la masse et **en ce que**, pour appliquer ladite polarisation directe aux bornes de la photodiode (1), le procédé comporte :
- le blocage du transistor de polarisation (2) de manière à le mettre dans un état bloquant,
- la mise dans un état passant du transistor additionnel (3).

3. Procédé selon l'une des revendications 1 et 2, **caractérisé en ce qu'**il comporte :
- une étape d'acquisition pour collecter un courant électrique à une fréquence supérieure à 100Hz dans ledit circuit de lecture (4) si la photodiode est polarisée en inverse et à sa température de travail.

4. Procédé selon la revendication 4, dans lequel le circuit de lecture (4) comporte une charge capacitive configurée pour stocker le courant électrique fourni par la photodiode (1), l'étape d'acquisition comportant la collection d'un signal stocké dans la charge capacitive à une fréquence supérieure à 100Hz.

5. Procédé selon l'une quelconque des revendications 1 à 4, **caractérisé en ce que** la seconde température est égale à -73°C.

6. Procédé selon l'une quelconque des revendications 1 à 5, **caractérisé en ce que** la première température est la température ambiante.

7. Procédé selon l'une quelconque des revendications 1 à 5, **caractérisé en ce que** la température de travail est comprise entre -225°C et -73°C.

8. Procédé selon l'une quelconque des revendications 1 à 6, **caractérisé en ce que** une photodiode est à base de CdHgTe, InSb ou InGaAs.

## Patentansprüche

1. Verfahren zur Inbetriebnahme eines Infrarotsensors, das folgende Schritte umfasst:
- Lieferung des Infrarotsensors, der mit einer Fotodiode (1) und einer Leseschaltung (4) versehen ist, die an die Fotodiode (1) angelegt ist,
- Absenken der Temperatur der Fotodiode (1) von einer ersten Temperatur auf eine Arbeitstemperatur, die unter der ersten Temperatur und unter - 73°C liegt,
- Anlegen einer Vorwärtsvorspannung an die Klemmen der Fotodiode (1) zur Erzeugung eines Majoritätsträgerstroms während des Absenkens der Temperatur von der ersten auf eine zweite Temperatur, die höher als die oder gleich der Arbeitstemperatur ist, und
- Anlegen einer Rückwärtsvorspannung an die Klemmen der Fotodiode (1), nachdem die Fotodiode (1) die Arbeitstemperatur erreicht hat, sodass die Fotodiode (1) ein optisches Signal in ein Elektrosignal umwandelt, dabei aber die Temperatur der Fotodiode (1) auf der Arbeitstemperatur hält.

2. Verfahren nach Anspruch 1, **dadurch gekennzeichnet, dass** der Infrarotsensor einen Vorspannungstransistor (2) umfasst, der mit der Fotodiode (1) in Serie geschaltet ist, und einen zusätzlichen Transistor (3), bei dem eine erste Klemme an die gemeinsame Klemme des Vorspannungstransistors (2) und der Fotodiode (1) gelegt ist, und eine zweite Klemme an Masse gelegt ist, sowie dadurch, dass das Verfahren zum Anlegen der genannten Vorwärtsvorspannung an die Klemmen der Fotodiode (1) folgende Schritte umfasst:
- Blockierung des Vorspannungstransistors (2), um ihn in einen blockierenden Zustand zu bringen,
- Versetzen des zusätzlichen Transistors (3) in einen leitenden Zustand.

3. Verfahren nach einem der Ansprüche 1 und 2, **dadurch gekennzeichnet, dass** es umfasst:
- einen Schritt der Erfassung, um in der Leseschaltung (4) einen elektrischen Strom bei einer Frequenz von über 100Hz zu erfassen, wenn die Fotodiode negativ und auf ihrer Arbeitsspannung vorgespannt wird.

4. Verfahren nach Anspruch 4, bei dem die Leseschaltung (4) eine kapazitive Last umfasst, die so konfiguriert ist, dass sie den von der Fotodiode (1) gelieferten elektrischen Strom speichert, wobei der Erfassungsschritt die Erfassung eines in der kapazitiven Last bei einer Frequenz von über 100Hz gespeicherten Signals umfasst.

5. Verfahren nach einem der Ansprüche 1 bis 4, **dadurch gekennzeichnet, dass** die zweite Temperatur gleich -73°C ist.

6. Verfahren nach einem der Ansprüche 1 bis 5, **dadurch gekennzeichnet, dass** die erste Temperatur die Umgebungstemperatur ist.

7. Verfahren nach einem der Ansprüche 1 bis 5, **dadurch gekennzeichnet, dass** die Arbeitstemperatur -225 bis -73°C beträgt.

8. Verfahren nach einem der Ansprüche 1 bis 6, **dadurch gekennzeichnet, dass** die Fotodiode eine Fotodiode auf Basis von CdHgTe, InSb oder InGaAs ist.

## Claims

1. Method for putting an infrared detector into operation comprising
- providing the infrared detector equipped with a photodiode (1) and with a readout circuit (4) connected to the photodiode (1),
- lowering the temperature of the photodiode (1) from a first temperature to a working temperature lower than the first temperature and lower than -73°C,
- applying a forward bias to the terminals of the photodiode (1) to generate a majority carrier current during lowering of the temperature from the first temperature to a second temperature higher than or equal to the working temperature, and
- applying a reverse bias to the terminals of the photodiode (1) after the photodiode (1) has reached the working temperature so that the photodiode (1) transforms an optic signal into an electric signal while keeping the temperature of the photodiode (1) at the working temperature.

2. Method according to claim 1, **characterized in that** the infrared detector comprises a bias transistor (2) connected in series with the photodiode (1) and an additional transistor (3) having a first terminal connected to the common terminal of the bias transistor (2) and photodiode (1) and a grounded second terminal and **in that**, to apply said forward bias to the terminals of the photodiode (1), the method comprises:
- turn-off of the bias transistor (2) so as to place it in an off state,
- switching the additional transistor (3) to an on state.

3. Method according to one of claims 1 and 2, **characterized in that** it comprises:
- an acquisition step to collect an electric current at a frequency higher than 100Hz in said readout circuit (4) if the photodiode is reverse biased and at its working temperature.

4. Method according to claim 4, wherein the readout circuit (4) comprises a capacitive charge configured to store the electric current supplied by the photodiode (1), the acquisition step comprising collecting a signal stored in the capacitive charge at a frequency higher than 100Hz.

5. Method according to any one of claims 1 to 4, **characterized in that** the second temperature is equal to -73°C.

6. Method according to any one of claims 1 to 5, **characterized in that** the first temperature is ambient temperature.

7. Method according to any one of claims 1 to 5, **characterized in that** the working temperature is comprised between -225°C and -73°C.

8. Method according to any one of claims 1 to 6, **characterized in that** the photodiode is made from CdHgTe, InSb or InGaAs.
